# EUROPÄISCHE PATENTSCHRIFT

(11) **EP 4 031 403 B1**
(45) Veröffentlichungstag und Bekanntmachung des Hinweises auf die Patenterteilung: **04.11.2026**
(21) Anmeldenummer: 20793240.1
(22) Anmeldetag: 15.09.2020
(51) Int. Cl.: B60L 53/14

(54) **LADEANSCHLUSSVORRICHTUNG MIT ENERGIEMESSVORRICHTUNG FÜR ELEKTROFAHRZEUGE**
CHARGING DEVICE WITH ENERGY METER FOR ELECTRIC VEHICLES
DISPOSITIF DE PRISE DE CHARGE À DISPOSITIF DE MESURE D'ÉNERGIE POUR VÉHICULES ÉLECTRIQUES

(30) Priorität: 16.09.2019 DE 102019006540
(43) Veröffentlichungstag der Anmeldung: 27.07.2022
(73) Patentinhaber: KEBA Energy Automation GmbH, 4040 Linz (AT)
(72) Erfinder: WEIDINGER, Gerhard, 4614 Marchtrenk (AT); EILMSTEINER, Heribert, 4020 Linz (AT)
(74) Vertreter: Burger, Hannes
(86) Internationale Anmeldenummer: PCT/AT2020/060333
(87) Internationale Veröffentlichungsnummer: WO 2021/051148

(56) Entgegenhaltungen:
- EP-A1- 2 552 048
- DE-A1- 102010 032 580
- DE-A1- 102010 046 174
- DE-A1- 102011 010 319
- US-A1- 2010 241 542

## Beschreibung

Die Erfindung betrifft eine Ladeanschlussvorrichtung für Elektrofahrzeuge in Kombination mit einer Energiemessvorrichtung, wie dies in den Ansprüchen angegeben ist.

Es ist allgemein bekannt, dass zum Aufladen bzw. Regenerieren des Energiespeichers eines elektrisch betriebenen Fahrzeuges ein solches Fahrzeug für eine gewisse Zeit abgestellt und mit einer elektrischen Energiequelle, üblicherweise dem örtlich vorhandenen Stromnetz, elektrisch verbunden wird. Moderne elektrische Fahrzeuge haben dabei mittlerweile eine akzeptable Reichweite von mehreren 100km, die mit einem voll aufgeladenen Energiespeicher zurückgelegt werden können, und weiters eine entsprechend hohe Antriebsleistung in der Größenordnung von 100kW oder mehr, was eine komfortable und rasche Fortbewegung ermöglicht.

Im Vergleich zu Fahrzeugen, welche Verbrennungskraftmaschinen für den Antrieb nutzen und während nur sehr kurzer Stillstandszeit in der Regel mit einem flüssigen oder gasförmigen Energieträger betankt werden, dauert der Ladevorgang der heute für Elektrofahrzeuge üblichen elektrochemischen Energiespeicher relativ lange. Um die Einsatzzeit bzw. Verfügbarkeit eines elektrischen Fahrzeuges zu verbessern, wird daher danach getrachtet, die Ladezeit möglichst kurz zu halten, wofür jedoch während dem Ladevorgang eine erhebliche elektrische Leistung benötigt wird. Diese muss vom elektrischen Netz bezogen, typischerweise über die Ladeelektronik im Fahrzeug umgewandelt und schließlich in den Energiespeicher des Fahrzeuges übertragen werden. Die Größenordnung der Ladeleistung liegt heute im Bereich von bis zu 22kW oder auch mehr, und ist damit deutlich höher als die elektrische Leistung, die beispielsweise von einer üblichen Haushaltssteckdose bezogen werden kann. Elektrisch betriebene Kraftfahrzeuge stellen also im Vergleich zu anderen in Haushalten üblichen, elektrischen Verbrauchern durchaus Großverbraucher dar. Selbst wenn ein Stromanschluss mit prinzipiell ausreichend hoher elektrischer Anschlussleistung zur Verfügung steht, kann es aufgrund der Gesamtbelastung in Teilen des Stromnetzes zu zeit- oder situationsabhängigen Einschränkungen bei der tatsächlich verfügbaren Leistung kommen.

Für den Ladevorgang elektrischer Kraftfahrzeuge - soweit es sich nicht um Kleinfahrzeuge in der Art eines Elektrofahrrades oder um Vergleichbares handelt - sind daher spezielle Ladeanschlussvorrichtungen erforderlich oder zumindest zweckmäßig, welche im Gegensatz zu einer herkömmlichen Steckdose nicht nur eine entsprechend hohe elektrische Anschlussleistung bereitstellen bzw. übertragen können, sondern auch zusätzliche Kommunikationsmittel aufweisen, mit denen die Ladeelektronik eines angeschlossenen Fahrzeuges die tatsächlich jeweils beziehbare Ladeleistung ermitteln kann bzw. auf die aktuelle Netzsituation reagieren kann, ohne das Netz bzw. die Zuleitung zu überlasten und damit eine Abschaltung zu verursachen. Weiters sind in solchen Ladeanschlussvorrichtungen eine Reihe von Sicherheitseinrichtungen implementiert, beispielsweise eine Sperrvorrichtung, die ein unbefugtes Abstecken oder ein Abstecken unter Volllast mit entsprechender Lichtbogenbildung verhindert. Die entsprechenden Ladeanschlussvorrichtungen sorgen typischerweise auch dafür, dass beim Auftreten von Fehlerströmen, bei Überlast und fallweise bei unzulässigen Rückspeiseströmen abgeschaltet bzw. entsprechend signalisiert wird.

Derartige Ladeanschlussvorrichtungen werden beispielsweise in den Druckschriften US 4,532,418 A, DE 42 13 414 C2, FR 2 766 950 A1, JP 11-122714 A, US 6,362,594 B2, WO 2007/141543 A2, WO 2010/011545 A1, WO 2010/133959 A2 und AT 507 605 A1 beschrieben. Die US 2010/0241542 A1 beschreibt eine Ladestation für Elektrofahrzeuge mit einer Fahrzeugidentifikation. Dabei kann ein angeschlossenes Fahrzeug identifiziert und ein Ladevorgang diesem Fahrzeug zugeordnet werden. Die Druckschrift betrifft jedoch nicht die Anordnung einer Energiedaten-Speichervorrichtung als internen Speicher einer Energiemessvorrichtung in einem eichrechtlich relevanten Teilabschnitt der Energiemessvorrichtung und offenbart auch keine Trennung zwischen einer nach Eichgesetzen und/oder Messrichtlinien zertifizierten Mess- und Auswertungssoftware der Energiemessvorrichtung und einer nicht entsprechend zertifizierten Betriebssoftware der Steuervorrichtung. Die EP 2 552 048 A1 betrifft ein Messdatenverwaltungsverfahren und ein Messdatenverwaltungssystem. Diese Druckschrift offenbart jedoch keine Ladeanschlussvorrichtung für Elektrofahrzeuge mit einer Energiemessvorrichtung, deren Energiedaten-Speichervorrichtung als interner Speicher der Energiemessvorrichtung ausgebildet und in einem eichrechtlich relevanten Teilabschnitt der Energiemessvorrichtung angeordnet ist. Ebenso wenig offenbart diese Druckschrift eine Speicherung von Energiedaten mehrerer Benutzer in datentechnisch unsignierter Form in einem solchen internen Speicher der Energiemessvorrichtung.

Der Stromanschluss, sowohl netzseitig als auch fahrzeugseitig, ist aufgrund der hohen zu übertragenden Leistung in der Regel als dreiphasiger bzw. mehrphasiger Starkstromanschluss mit entsprechend großen Leitungsquerschnitten von typisch 4 bis 6 mm², fallweise aber auch mit bis zu 16 mm² ausgeführt. Zweckmäßigerweise sind die Ladeanschlussvorrichtungen in unmittelbarer Nähe zu den Abstellplätzen der jeweiligen Elektrofahrzeuge installiert, wobei es sich üblicherweise um Garagen, Tiefgaragen, überdachte Parkflächen und dergleichen handelt, welche privat, fallweise aber auch öffentlich zugänglich oder zumindest für eine größeren Personenkreis zugänglich sein können.

Das Gehäuse solcher Ladeanschlussvorrichtungen muss dabei die hantierenden Personen vor dem Kontakt mit spannungsführenden Teilen im Innenraum bzw. vor lebensgefährlichen Stromschlägen schützen. Darüber hinaus schützt das Gehäuse die innenliegenden elektrischen und elektronischen Komponenten vor mechanischer Beschädigung sowie Schmutz und Feuchtigkeit und weiteren im Umfeld von Fahrzeugen zu erwartenden Stoffen, wie beispielsweise Streusalz oder vergleichbar wirkende Auftaumittel, und stellt damit deren dauerhaft zuverlässige Funktion sicher.

Die Ladestationen neuerer Art werden bereits als relativ kompakte Einheiten gefertigt, deren Funktion und Sicherheit vor der Auslieferung geprüft wird. Alle für die Funktion und Sicherheit der Einheit relevanten Komponenten sind in diesem geschlossenen Gehäuse angeordnet und damit vor Beschädigung oder Manipulation geschützt. Üblicherweise sind auch nur die Anschlussklemmen für den Anschluss an das Stromnetz und gegebenenfalls Schnittstellen für eine Anbindung an Kommunikationsnetze über separat abnehmbare Gehäuseteile für den mit der Installation und Inbetriebnahme betrauten Fachmann zugänglich. Dieser ist verantwortlich für die ordnungsgemäße Installation bzw. Montage und den Anschluss an das Stromnetz.

Mit zunehmender Verbreitung von Elektrofahrzeugen besteht auch der Wunsch bzw. das Erfordernis einer öffentlich verfügbaren bzw. allgemein zugänglichen Ladeinfrastruktur. In diesem Zusammenhang wird es zunehmend auch erforderlich sein, die von Energieversorgungsunternehmen bzw. Netzbetreibern bereitgestellte elektrische Energie unter anderem in Abhängigkeit des jeweiligen Verbrauchs in Rechnung zu stellen. Diesen Anforderungen entsprechende Ladeanschlussvorrichtungen können darüber hinaus Mittel zur Autorisierung bzw. Freigabe des Energiebezugs beinhalten, beispielsweise via einen kodierten RFID-Transponder oder via einen Schlüsselschalter, oder technische Identifikationsmittel umfassen, um den Benutzer zu identifizieren bzw. um Informationen für Verrechnungszwecke zu erfassen und gegebenenfalls diese Daten über datentechnische Netzwerkverbindungen mit zentralen Clearing-Stellen auszutauschen. Weiters können solche Ladeanschlussvorrichtungen auch Mittel zur Messung und Überwachung der übertragenen Leistung, des Stromes, oder der Energiemenge beinhalten. Vor allem dann, wenn der Bezug der elektrischen Energie einer Abrechnung unterliegt, ist es besonders wichtig, dass diese Abrechnung stets korrekt und den tatsächlichen Gegebenheiten entsprechend ausgeführt werden kann. Dabei sollen trotz umfangreicher Funktionalitäten der Ladeanschlussvorrichtung die Herstellungskosten möglichst gering gehalten werden, um eine Etablierung der Ladeanschlussvorrichtung bzw. einen Ausbau von öffentlich bzw. allgemein nutzbarer Ladeinfrastruktur zu begünstigen. Dies ist mit den bisher bekannten Systemen nur bedingt zufriedenstellend erzielbar.

Die DE 10 2010 032580 A1 offenbart eine gattungsgemäße Elektrofahrzeug-Ladeanschlussvorrichtung. Die Energiemessvorrichtung dieser Ladeanschlussvorrichtung ist ein Messgerät mit einem Strommesser. Der Messgerätezählerstand des Strommessers kann durch das Messgerät ausgegeben werden. Dies kann verschlüsselt und signiert erfolgen. Hierzu kann im Messgerät die Signatureinrichtung angeordnet sein. In dem Messgerät kann eine CPU vorhanden sein und der Messgeräteschlüssel aus privatem Messgeräteschlüssel und öffentlichem Messgeräteschlüssel gespeichert sein. Um die Abrechnungsdaten fest mit der Nutzeridentifikation zu verknüpfen, wird vorgeschlagen, dass ein Datenpaket umfassend zumindest den Messgerätezählerstand und die Nutzeridentifikation signiert an die Abrechnungszentrale übermittelt wird.

Die DE 10 2010 046174 A1 beschreibt ein Verfahren sowie eine Vorrichtung zur Überprüfung einer in einer Messstation, insbesondere einer Ladestation für Elektrofahrzeuge, bereitgestellten Zeitinformation. Um die Zeitinformation überprüfen zu können, wird vorgeschlagen, dass die in der Messstation bereitgestellte Zeitinformation erfasst wird, dass die Zeitinformation von der Messstation an eine von der Ladestation räumlich getrennte Prüfstelle übermittelt wird, dass in der Prüfstelle die übermittelte Zeitinformation mit einer in der Prüfstelle bereitgestellten Zeitnormalen verglichen wird und dass das Vergleichsergebnis in der Prüfstelle abgespeichert wird. Dadurch wird die in einer Messstation bereitgestellte Zeitinformation gegenüber Manipulationen und Verfälschungen gesichert. Zudem wird dadurch ein Energiezähler zur Verfügung gestellt, der hinsichtlich der Uhrzeit eichrechtlichen Bedingungen genügt.

Die DE 10 2011 010319 A1 offenbart ein Verfahren zum Sichern einer Ladestation, insbesondere einer Ladestation für Elektrofahrzeuge, umfassend: Erfassen von Ladevorgänge repräsentierenden Messdaten, Speichern der erfassten Messdaten in einem Messdatenspeicher, Überwachen der Integrität der Ladestation, und bei einer detektierten Verletzung der Integrität der Ladestation Setzen eines Steuermarkers, welcher zumindest mittelbar ein Löschen der Messdaten in dem Messdatenspeicher bewirkt.

Aufgabe der vorliegenden Erfindung war es, die Nachteile des Standes der Technik zu überwinden und eine Vorrichtung zur Verfügung zu stellen, mittels derer der Bezug von elektrischer Energie an einer allgemein zugänglichen Ladeanschlussvorrichtung für einen Betreiber und auch für Benutzer der Ladeanschlussvorrichtung möglichst exakt und somit mess- und eichrechtlich zertifizierbar erfassbar ist. Gleichwohl sollen die Kosten zur Schaffung eines derartigen Systems möglichst gering gehalten werden.

Diese Aufgabe wird durch eine Vorrichtung gemäß den Ansprüchen gelöst.

Die erfindungsgemäße Ladeanschlussvorrichtung für Elektrofahrzeuge umfasst:
- zumindest eine erste Schnittstelle zum Beziehen von elektrischer Energie aus einem ortsfesten Stromversorgungsnetz,
- zumindest eine zweite Schnittstelle zur gesteuerten Abgabe von elektrischer Energie an ein Elektrofahrzeug,
- eine elektronische Steuervorrichtung mit welcher ein Ladevorgang eines Elektrofahrzeugs überwachbar und/oder beeinflussbar ist,
- eine Leistungsschaltvorrichtung mit einem ersten Schaltzustand in welchem eine Bereitstellung von elektrischer Energie an der zumindest einen zweiten Schnittstelle freischaltbar ist und mit einem zweiten Schaltzustand in welchem eine Bereitstellung von elektrischer Energie an der zumindest einen zweiten Schnittstelle unterbindbar ist,
- eine Energiemessvorrichtung zum Messen der über die Ladeanschlussvorrichtung an ein Elektrofahrzeug abgegebenen elektrischen Energie,
- eine elektronische Energiedaten-Speichervorrichtung zum Speichern der von der Energiemessvorrichtung gemessenen Energiedaten;
- ein Gehäuse in welchem wenigstens die elektronische Steuervorrichtung und die Leistungsschaltvorrichtung und gegebenenfalls die Energiemessvorrichtung untergebracht sind.

Die elektronische Energiedaten-Speichervorrichtung ist dabei als interner Speicher der Energiemessvorrichtung ausgebildet, in welchem Speicher die Energiebezüge von mehreren unterschiedlichen Benutzern je Ladevorgang hinterlegbar sind. Diese Energiedaten über die jeweiligen Energiebezüge werden dabei in datentechnisch unsignierter Form, insbesondere lediglich als Rohdaten, in der elektronischen Energiedaten-Speichervorrichtung hinterlegt. Insbesondere ist die Energiemessvorrichtung dazu eingerichtet, die Energiedaten von mehreren Benutzern der Ladeanschlussvorrichtung datentechnisch unsigniert im internen Speicher zu hinterlegen.

Die erfindungsgemäße Ladeanschlussvorrichtung bringt den Vorteil mit sich, dass dadurch eine Ladeanschlussvorrichtung geschaffen ist, welche die diversen Energiebezüge einer Mehrzahl von unterschiedlichen Kunden bzw. Benutzern der Ladeanschlussvorrichtung messen und bei relativ geringem Bedarf an Speicherplatz langfristig aufzeichnen kann. Neben dem relativ geringen Speicherbedarf entsprechen die von der Energiemessvorrichtung erfassten Energiedaten besonderes exakt den tatsächlichen Energiebezügen, weil Asynchronitäten in Bezug auf den Start und das Ende eines Ladevorganges gegenüber dem Start und Ende der Energiemessung durch die Energiemessvorrichtung vermieden oder hintan gehalten werden. Damit kann eine bezogene Energiemenge einem Ladevorgang bzw. einem Kunden der Ladeanschlussvorrichtung mit vernachlässigbar kleinen, zeitlichen Abtastverzögerungen zugeordnet werden. Die anspruchsgemäße Datensatz-Speicherung erfordert dabei eine nur relativ geringe Rechenintensität. Erfindungsgemäß kann nun auch mit relativ geringen Prozessorleistungen der Energiemessvorrichtung eine exakte Energieverbrauchsmessung erzielt werden. Dadurch können auch möglichst geringe Kosten in Zusammenhang mit der Herstellung einer solchen Ladeanschlussvorrichtung erzielt werden.

Des Weiteren ist die Energiemessvorrichtung, insbesondere deren Mess- und Auswertungssoftware, nach länderspezifischen Eichgesetzen und/oder Messrichtlinien zertifiziert und/oder bewertet und ist somit die Konformität zu den jeweiligen nationalen Richtlinien, Normen und Gesetzen bestätigt. Dadurch kann gewährleistet werden, dass die Energiemessvorrichtung messtechnischen und/oder eichrechtlichen Anforderungen entspricht und der Bezug von elektrischer Energie sowohl für den Betreiber, als auch für den Kunden bzw. Benutzer der Ladeanschlussvorrichtung rechtskonform ablaufen kann.

Entsprechend einer bevorzugten Ausführungsform ist die Energiemessvorrichtung mit ihrer internen Energiedaten-Speichervorrichtung innerhalb des Gehäuses der Ladeanschlussvorrichtung untergebracht.

Ferner ist die Energiedaten-Speichervorrichtung in einem eichrechtlich relevanten Teilabschnitt der Energiemessvorrichtung angeordnet. Dadurch können in Bezug auf die Energiemessvorrichtung extern angeordnete und separat zu zertifizierende Komponenten bzw. Komponentenansammlungen erübrigt werden, wodurch eine geringere Komplexität der Ladeanschlussvorrichtung erzielbar ist. Zudem sind dadurch auch geringere Kosten in Bezug auf Herstellung und Zertifizierung der Ladeanschlussvorrichtung erzielbar.

Darüber hinaus ist die Steuervorrichtung in ihren Abläufen und Funktionen zumindest teilweise durch Betriebssoftware gesteuert oder beeinflusst und ist diese Betriebssoftware in eichrechtlicher und/oder messtechnischer Hinsicht nicht zertifiziert, sodass hier keine Konformität zu den jeweiligen nationalen Gesetzen und Richtlinien bezüglich der Energiemessung besteht. Die Betriebssoftware für den Betrieb bzw. den grundlegenden Funktionsumfang der Ladeanschlussvorrichtung kann dadurch relativ einfach aktualisiert bzw. häufiger upgedatet werden. Änderungen in der Betriebssoftware der Ladeanschlussvorrichtung müssen dadurch nicht zwingend einer aufwändigen Neu-Zertifizierung unterzogen werden. Eichrechtlich relevante Softwarebestandteile in der Energiemessvorrichtung in Zusammenhang mit einer exakten bzw. rechtskonformen Messung und Erfassung des Energiebezuges bleiben durch diese Maßnahmen von einem Update der Betriebssoftware unberührt. Die Kosten und allfällige Komplikationen in Zusammenhang mit notwendigen bzw. gewünschten Softwareupdates an der Ladeanschlussvorrichtung können so möglichst gering gehalten werden.

Weitere vorteilhafte Ausgestaltungen der Ladeanschlussvorrichtung nach Anspruch 1 werden nachfolgend beschrieben.

Vorteilhaft ist auch eine Ausprägung, gemäß der die Energiemessvorrichtung und die Steuervorrichtung jeweils eigene Mikrocontroller mit jeweils eigener Firmware aufweisen. Dadurch sind zwei getrennte bzw. baulich eigenständige Funktionskomponenten vorhanden, wodurch eine Umsetzung von messtechnischen Anforderungen und/oder eichrechtlichen Regulierungen erleichtert werden kann.

Gemäß einer Weiterbildung kann die Energi emessvorrichtung dazu eingerichtet sein, die gespeicherten Energiedaten an die Steuervorrichtung der Ladeanschlussvorrichtung zu übergeben, und die Steuervorrichtung dazu eingerichtet sein, diese Energiedaten in datentechnisch signierter Form an ein externes, zentrales Verwaltungssystem zu übergeben. Dadurch sind die Energiedaten vor unzulässigen absichtlichen Veränderungen oder vor Austausch geschützt. Nachdem die datentechnische Signierung durch die Steuervorrichtung umgesetzt wird, kann die Rechenleistung der Energiemessvorrichtung in vorteilhafter Weise gering gehalten werden. Die datentechnische Signierung der Energiedaten in der Ladeanschlussvorrichtung wird dabei bevorzugt nur nach Bedarf für den Zweck der Weitergabe an ein zentrales Verwaltungsystem vorgenommen.

Insbesondere kann es zweckmäßig sein, wenn die Steuervorrichtung dazu eingerichtet ist, die Energiedaten in einem standardisierten, vordefinierten Datenformat für Energiezählvorrichtungen, beispielsweise im Datenformat SML oder OCMF aufzubereiten. Dadurch ist die rechenintensive Aufbereitung der Energiedaten in ein standardisiertes Datenformat der Steuervorrichtung der Ladeanschlussvorrichtung auferlegt. Durch den Verzicht auf eine externe Weitergabe von mess- und eichrechtlich relevanten Energiedaten ausgehend von der Energiemessvorrichtung während eines Ladevorganges, können die jeweiligen Messwerte der Energiemessvorrichtung, insbesondere zu den Zeitpunkten des Starts und des Endes eines Ladevorganges, schnell und damit quasi verzögerungsfrei im internen Speicher der Energiemessvorrichtung abgelegt werden.

Darüber hinaus kann die Energiemessvorrichtung dazu eingerichtet sein, eine datentechnische Prüfsumme, beispielsweise einen CRC-Wert, zu den erfassten Energiedaten zu berechnen und diese Prüfsumme gemeinsam mit den Energiedaten in datentechnisch unsignierter Form in der Energiedaten-Speichervorrichtung zu hinterlegen. Dadurch können eventuelle Datenfehler in Bezug auf die Energiedaten in der Energiedaten-Speichervorrichtung erkannt werden. Die entsprechenden Energiedaten sind somit vor zufälligen oder unbeabsichtigten Veränderungen geschützt. Die erforderliche Rechen- bzw. Prozessorleistung der Energiemessvorrichtung kann dabei trotzdem relativ gering gehalten werden. Auch das hierfür benötigte Speichervolumen der Energiedaten-Speichervorrichtung kann in vorteilhafter Weise relativ gering gehalten werden.

Des Weiteren kann eine Identifikationsvorrichtung zur Identifizierung unterschiedlicher Benutzer der Ladeanschlussvorrichtung ausgebildet sein. Dadurch kann eine Multi-User-Nutzbarkeit der Ladeanschlussvorrichtung durch verschiedene Benutzer ermöglicht und eine individuell zugeordnete Abrechnung der Energiekosten gewährleistet werden.

Entsprechend einer vorteilhaften Ausgestaltung sind die Energiemessvorrichtung und die Steuervorrichtung dazu eingerichtet, am Ende eines Ladevorganges ein datentechnisch signiertes Datenpaket mit allen Informationen bzw. Energiedaten über den abgeschlossenen Ladevorgang an das zentrale Verwaltungssystem zu übertragen. Diese Informationen bzw. Energiedaten können insbesondere den Benutzer der Ladeanschlussvorrichtung, beispielsweise eine Benutzer-Identifikation oder eine Transaktionsnummer, den Beginn-Zählerstand und den End-Zählerstand der Energiemessvorrichtung oder einen Differenzwert zwischen dem End-zählerstand und dem Beginn-Zählerstand umfassen. Gegebenenfalls können diese Informationen bzw. Energiedaten auch die Beginn-Uhrzeit und die End-Uhrzeit des Ladevorganges umfassen. Dadurch wird in vorteilhafter Art und Weise nur zum Schluss des Ladevorganges ein einziges, signiertes Datenpaket an das zentrale Verwaltungssystem übertragen. Demzufolge wird je Ladevorgang eines Benutzers nur einmal ein signiertes Datenpaket berechnet, wodurch die Rechen- bzw. Bearbeitungsbelastung innerhalb der Ladeanschlussvorrichtung, insbesondere für die Energiemessvorrichtung und für die Steuervorrichtung, in vorteilhafter Art und Weise gering gehalten werden kann. Die sogenannte "Busy-Time" bzw. Belegungszeit der Ladeanschlussvorrichtung kann dadurch minimiert werden. Dadurch ist es auch möglich, relativ kostengünstige Hardwarekomponenten bzw. Mikrocontroller einzusetzen und trotzdem die Anforderungen an eine moderne Ladeanschlussvorrichtung optimal zu erfüllen.

Zum besseren Verständnis der Erfindung wird diese anhand der nachfolgenden Figuren näher erläutert.
- Fig. 1: eine Ausführungsform der Ladeanschlussvorrichtung in perspektivischer Ansicht auf die Gehäusevorderseite;
- Fig. 2: ein beispielhaftes Blockschaltbild zur Veranschaulichung von Komponenten und Funktionalitäten der Ladeanschlussvorrichtung.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

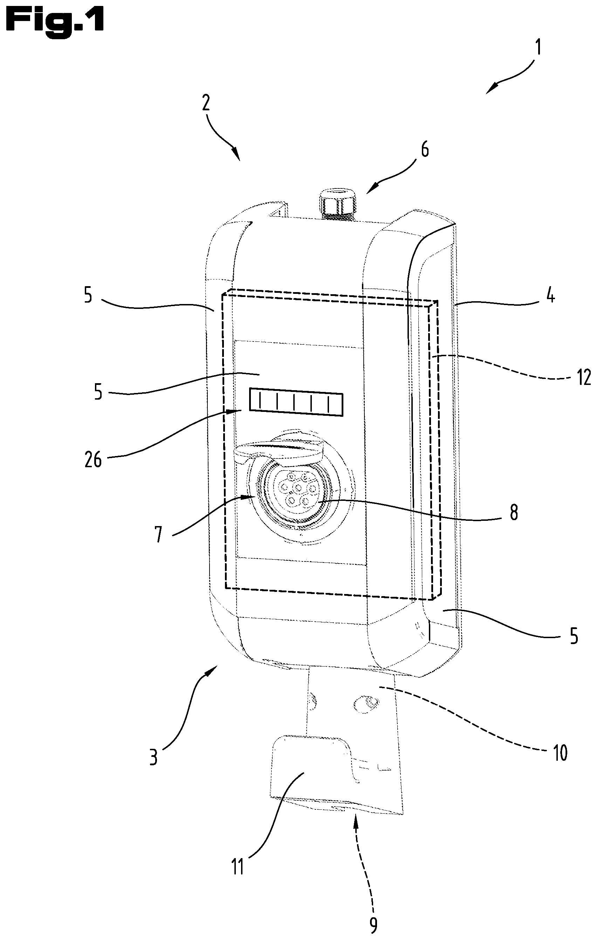

In den Fig. 1 ist eine beispielhafte Ausführungsform einer Ladeanschlussvorrichtung 1 für Elektrofahrzeuge veranschaulicht. Diese Ladeanschlussvorrichtung 1 ist zum Aufladen bzw. Regenerieren eines Energiespeichers, insbesondere einer oder mehrerer Batterien, eines Elektrofahrzeuges vorgesehen, wobei die Ladeanschlussvorrichtung 1 das Bindeglied zwischen einem ortsfesten Stromversorgungsnetz und einer Ladevorrichtung bzw. des Energiespeichers des Elektrofahrzeugs bildet. Die Ladevorrichtung des Energiespeichers kann dabei als Bestandteil der Ladeanschlussvorrichtung 1 ausgebildet sein. In den derzeit üblichen Ausführungsformen ist die Ladevorrichtung jedoch vorzugsweise im Elektrofahrzeug selbst eingebaut. Die Ladeanschlussvorrichtung 1 stellt dann eine Art intelligente Stromtankstelle für Elektrofahrzeuge dar.

Die gezeigte Ladeanschlussvorrichtung 1 umfasst ein Gehäuse 2, welches seinerseits aus einem vorderen Gehäuseteil 3 und einem hinteren Gehäuseteil 4 gebildet ist, wobei der hintere Gehäuseteil 4 ortsfest, beispielsweise an einer Hauswand oder einer Säule, montiert ist und der vordere Gehäuseteil 3 bedarfsweise von dem hinteren Gehäuseteil 4 abgenommen werden kann. Im vorliegenden Ausführungsbeispiel ist der vordere Gehäuseteil 3 aus mehreren, weiteren Gehäuseteilen 5 gebildet.

An einer Oberseite des Gehäuses 2 ist eine erste Schnittstelle 6 zur Entnahme von elektrischer Energie aus dem ortsfesten Stromversorgungsnetz angeordnet. Über diese erste Schnittstelle 6 bezieht die Ladeanschlussvorrichtung 1 die elektrische Energie aus dem Stromversorgungsnetz, wobei im vorliegenden Ausführungsbeispiel die erste Schnittstelle 6 als fix verdrahtete Leitungsschnittstelle ausgeführt ist. Um die typischerweise benötigte, elektrische Leistung in die Ladeanschlussvorrichtung 1 bzw. von dort weiter zum Elektrofahrzeug übertragen zu können, sind elektrische Kabel mit einem Leitungsquerschnitt von zumindest 4 mm² vorgesehen.

Zur Abgabe der elektrischen Energie an das Elektrofahrzeug ist beispielsweise an einer Vorderseite des Gehäuses 2 zumindest eine zweite Schnittstelle 7 ausgebildet. Diese zumindest eine zweite Schnittstelle 7 umfasst eine Steckbuchse 8, in welche ein Stecker eines Ladekabels eines Elektrofahrzeugs eingeführt und verriegelt werden kann. Bei der dargestellten Ladeanschlussvorrichtung 1 ist an einer Unterseite des Gehäuses 2 eine weitere, zweite Schnittstelle 9 vorgesehen, an welcher ein fix mit der Ladeanschlussvorrichtung 1 verdrahtetes, flexibles Ladekabel angeschlossen sein kann, wobei am freien Ende des flexiblen Ladekabels ein Stecker ausgebildet ist, welcher in eine entsprechende Steckbuchse am Elektrofahrzeug eingesteckt werden kann. Ein entsprechender Ladekabelabgang 10 für das flexible Ladekabel der weiteren, zweiten Schnittstelle 9 ist hierbei an der Unterseite des Gehäuses 2 ersichtlich. Welche der Ausführungsformen der zweiten Schnittstelle 7, 9 nun tatsächlich an der Ladeanschlussvorrichtung 1 vorhanden ist und ob nur eine oder mehrere zweite Schnittstellen 7, 9 ausgebildet sind, kann nach Bedarf festgelegt werden. Bei einer Ausführung der zumindest einen, zweiten Schnittstelle 7, 9 als flexibles Ladekabel ist zweckmäßigerweise eine Ladekabelhalterung 11 vorgesehen, auf welcher das flexible Ladekabel bei Nichtgebrauch verstaut werden kann. Typischerweise sind die als Steckbuchse 8 ausgeführte zweite Schnittstelle 7 und die als Kabelabgang ausgeführte zweite Schnittstelle 9 als Alternativen an der Ladeanschlussvorrichtung 1 vorgesehen.

Das Gehäuse 2 der Ladeanschlussvorrichtung 1 umschließt eine Mehrzahl von elektrotechnischen bzw. elektronischen Komponenten, welche auf wenigstens einer Leiterplatte 12 angeordnet bzw. fixiert sein können und/oder anderweitig im Gehäuse gehaltert und verdrahtet sein können. Die elektrotechnischen bzw. elektronischen Komponenten steuern und/oder überwachen unter anderem den Ladevorgang des Elektrofahrzeuges und können weiters für die Gewährleistung der elektrotechnischen Sicherheit der Ladeanschlussvorrichtung vorgesehen sein. Im Zuge der Steuerung bzw. Überwachung des Ladevorgangs ist es ebenso nötig, verschiedene Messungen, beispielsweise zur Bestimmung der Stromstärke des an das Elektrofahrzeug übertragenen Stromes, vorzunehmen. Die dazu nötigen, elektrotechnischen bzw. elektronischen Komponenten können ebenso auf der wenigstens einen Leiterplatte 12 vorhanden sein.

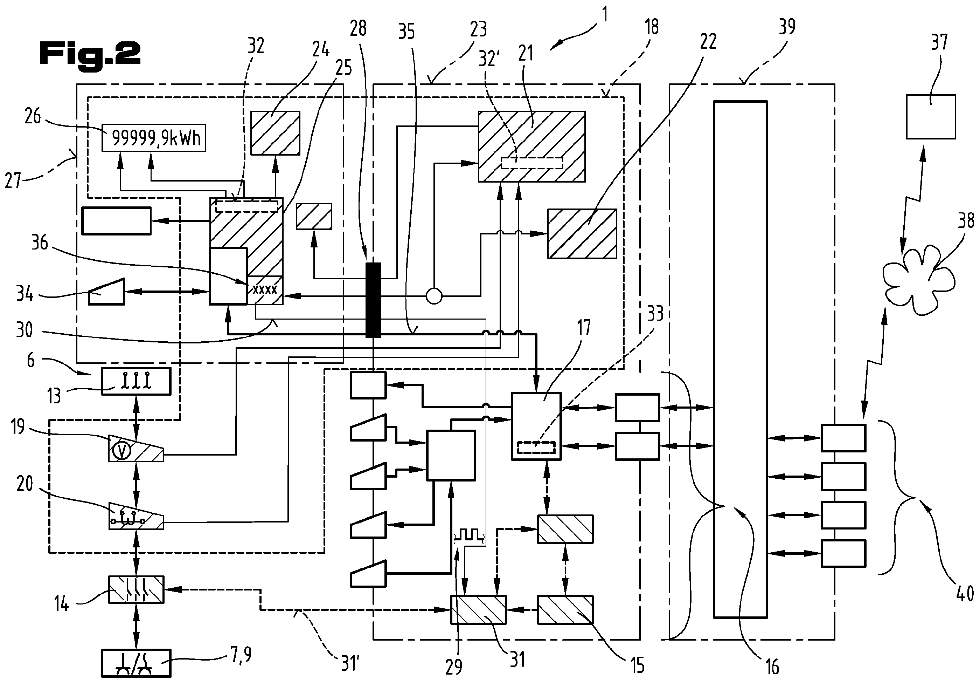

In Fig. 2 ist ein schematisches Blockschaltbild in Zusammenhang mit beispielhaft angeführten elektrotechnischen bzw. elektronischen Komponenten der Ladeanschlussvorrichtung 1 gezeigt. Diese umfassen insbesondere Anschlussklemmen 13 zum Verbinden einer Kabelzuleitung mit der ersten Schnittstelle 6 der Ladeanschlussvorrichtung 1, eine Leistungsschaltvorrichtung 14, beispielsweise einen Schütz oder einen Leistungs-Halbleiterschalter zum Herstellen bzw. Trennen einer elektrischen Verbindung zwischen der ersten Schnittstelle 6 und der zweiten Schnittstelle 7 bzw. der weiteren zweiten Schnittstelle 9 der Ladeanschlussvorrichtung 1, gegebenenfalls eine Fehlerstrom-Überwachungsvorrichtung 15, welche bei einem Fehlerstrom bzw. Erdschluss im Stromversorgungsnetz von der Ladeanschlussvorrichtung 1 bis zum Elektrofahrzeug den Stromkreis unterbricht, und eine zentrale Steuervorrichtung 16, welche vorzugsweise einen ersten Mikrocontroller 17 umfasst, der einzelne elektrotechnische bzw. elektronische Komponenten steuert bzw. mit diesen kommuniziert.

Die Ladeanschlussvorrichtung 1 umfasst weiters eine rein elektrotechnisch implementierte Energiemessvorrichtung 18 zum Messen der über die Ladeanschlussvorrichtung 1 an ein Elektrofahrzeug abgegebenen elektrischen Energie. Eine solche rein elektrotechnische Energiemessvorrichtung 18 ist im Gegensatz zu einem elektromechanischen Energiezähler kompakt und leichtgewichtig.

Die Energiemessvorrichtung 18 umfasst zumindest einen Spannungsgeber 19 je elektrischer Phase bzw. je elektrischem Pfad zur Leistungsschaltvorrichtung 14 und zumindest einen Stromwandler 20 je elektrischer Phase bzw. je elektrischem Pfad zur Leistungsschaltvorrichtung 14. Der zumindest eine Spannungsgeber 19 und der zumindest eine Stromwandler 20 sind mit einem Mess-Controller 21 verbunden und übergeben so die jeweiligen Spannungs- bzw. Stromwerte an den Mess-Controller 21. Der Mess-Controller 21 errechnet aus den übergebenen Signalen bzw. Werten die jeweils übertragene bzw. bezogene, elektrische Energiemenge.

Eine nicht-flüchtige Kalibrierdaten-Speichervorrichtung 22, insbesondere ein EEPROM-Speicher, ist ebenso wie die Steuervorrichtung 16 auf einer Hauptplatine 23 angeordnet. In der Kalibrierdaten-Speichervorrichtung 22 sind die für eine genaue Messung durch die Energiemessvorrichtung 18 erforderlichen Kalibrierdaten hinterlegt. Diese Kalibrierdaten sind geräteabhängig und variieren vor allem in Abhängigkeit der elektrischen Eigenschaften der Spannungsgeber 19 und der Stromwandler 20 bzw. in Abhängigkeit der ohmschen Widerstände der Leitungsverbindungen.

Die Energiemessvorrichtung 18 umfasst weiters eine nicht-flüchtige Energiedaten-Speichervorrichtung 24. In dieser Energiedaten-Speichervorrichtung 24 sind zumindest die von Ladesitzung zu Ladesitzung kontinuierlich ansteigenden Werte des Gesamtenergiebezuges an der Ladeanschlussvorrichtung 1 hinterlegbar.

Diese Energiedaten-Speichervorrichtung 24 ist mit einem eigenständigen Messdaten-Verwaltungscontroller 25 verbunden. Dieser Messdaten-Verwaltungscontroller 25 ist weiters mit einem Display 26 an der Ladeanschlussvorrichtung 1 verbunden. Insbesondere ist dieses Display 26 unmittelbar am Gehäuse 2 angeordnet und von einem Benutzer der Ladeanschlussvorrichtung 1 ablesbar. Dieses Display 26 ist zur Anzeige von mess- und eichrechtlich relevanten Daten in Form von Klartext vorgesehen. Insbesondere ist darauf der Gesamt-Energieverbrauch seit der ersten Inbetriebnahme der Energiemessvorrichtung 18 ablesbar. Alternativ oder in Kombination dazu kann am Display 26 die jeweilige Bezugsmenge von elektrischer Energie je Ladevorgang visualisiert und von einem Benutzer abgelesen werden.

Zumindest die Energiedaten-Speichervorrichtung 24 und der Messdaten-Verwaltungscontroller 25 sind bevorzugt auf einer baulich eigenständigen Messplatine 27 angeordnet. Diese Messplatine 27 ist über eine Steckerschnittstelle 28 mit der Hauptplatine 23 elektrisch verbindbar. Vorzugsweise dient dabei die Hauptplatine 23 als Trägerplatine für die Messplatine 27.

Die Energiemessvorrichtung 18 ist dazu eingerichtet, einen Energiefluss bzw. eine Energiefreischaltung an der zweiten Schnittstelle 7 bzw. 9 zu unterbinden, wenn die Energiemessvorrichtung 18 nicht imstande ist, einen Energiebezug messtechnisch bzw. eichrechtlich exakt zu erfassen bzw. zu messen. Dies kann aufgrund von Boot-Vorgängen der Energiemessvorrichtung 18, insbesondere des Messdaten-Verwaltungscontrollers 25 auftreten. Aber auch anderweitige Beeinflussungen bzw. Störungen können dazu führen, dass eine exakte Erfassung, insbesondere eine zeitsynchrone Bereitstellung und Messung eines Energiebezuges nicht möglich ist. Für den Fall, dass die Energiemessvorrichtung 18 nicht adäquat mess- bzw. erfassungsbereit ist, kann die Energiemessvorrichtung 18 eine Aktivierung der Leistungsschaltvorrichtung 14 unterbinden und damit einen Stromfluss zu der Abgangsschnittstelle, insbesondere zur zweiten Schnittstelle 7 bzw. 9 aktiv vermeiden. Dabei hat die Energiemessvorrichtung 18 für den Fall einer einzuleitenden Unterbindung oder Verweigerung eines Energieflusses zu der wenigstens einen zweiten Schnittstelle 7 bzw. 9 steuerungstechnisch priorisierten Einfluss auf die Schaltzustände der Leistungsschaltvorrichtung 14. Insbesondere weist die Leistungsschaltvorrichtung 14 einen ersten Schaltzustand (Aktivzustand) auf, in welchem eine Bereitstellung bzw. Übertragung von elektrischer Energie an die zumindest eine zweite Schnittstelle 7 bzw. 9 ermöglicht ist. Demgegenüber ist in einem zweiten Schaltzustand (Inaktivzustand) eine Bereitstellung bzw. Übertragung von elektrischer Energie an die zumindest eine zweite Schnittstelle 7 bzw. 9 unterbindbar. Im einfachsten Fall sind die beiden Schaltstellungen durch den Aktiv- bzw. Inaktivzustand eines elektromechanischen Leistungsschalters, insbesondere eines Schaltschütz oder eines Leistungs-Halbleiterschalters, definiert. Für jene Fälle, in denen die Energiemessvorrichtung 18 nicht messbereit bzw. nicht erfassungsbereit ist, bewirkt die Energiemessvorrichtung 18 eine Herstellung oder eine Beibehaltung des zweiten Schaltzustandes, also des Inaktivzustandes der Leistungsschaltvorrichtung 14. Dadurch wird eine Energieübertragung ausgehend von der Energiemessvorrichtung 18 steuerungstechnisch bzw. automatisch unterbunden.

Dabei kann die Energiemessvorrichtung 18 zur Abgabe bzw. Bereitstellung eines steuerungstechnischen Freigabe- bzw. Sperrsignals 29 ausgebildet sein. Hierzu ist die Energiemessvorrichtung 18 mittels wenigstens einer Steuerleitung 30, insbesondere wenigstens einer Signal- bzw. Datenleitung, mit der Steuervorrichtung 16 bzw. mit deren Leistungsschalter-Ansteuereinheit 31 verbunden. Die Steuervorrichtung 16 bzw. deren Leistungsschalter-Ansteuereinheit 31 ist zur Auswertung des steuerungstechnischen Freigabe- und/oder Sperrsignals 29 und zur auswertungsabhängigen Ansteuerung der Leistungsschaltvorrichtung 14 ausgebildet. Die Steuervorrichtung 16 bzw. deren Leistungsschalter-Ansteuereinheit 31 ist dabei über wenigstens eine Steuerleitung 31' mit der Leistungsschaltvorrichtung 14 verbunden. Dadurch ist die Leistungsschaltvorrichtung 14 in Abhängigkeit der Auswertungsergebnisse des Freigabe-und/oder Sperrsignals 29 von der Steuervorrichtung 16 bzw. von der Leistungsschalter-Ansteuereinheit 31 fallspezifisch aktivier- und deaktivierbar.

Zweckmäßig ist es, wenn die Energiemessvorrichtung 18 zur Abgabe bzw. Bereitstellung eines Sperrsignals eingerichtet, wenn seitens der Energiemessvorrichtung 18 fehlende Bereitschaft zum Messen bzw. Erfassen eines Energieflusses zu der wenigstens einen zweiten Schnittstelle 7 bzw. 9 gegeben ist. Umgekehrt ist die Energiemessvorrichtung 18 zur Abgabe bzw. Bereitstellung eines Freigabesignals eingerichtet, wenn die Energiemessvorrichtung 18 funktionsbereit ist und einen Energiefluss zur zweiten Schnittstelle 7 mess- und eichrechtskonform messen bzw. erfassen kann.

Die steuerungstechnischen bzw. datentechnischen Auswertungen durch die Steuervorrichtung 16 bzw. durch die Leistungsschalter-Ansteuereinheit 31 können beispielsweise durch eine logische UND-Verknüpfung des Freigabe- bzw. Sperrsignals 29 der Energiemessvorrichtung 18 mit wenigstens einem Freigabekriterium oder einer Schaltanforderung von Seiten der Steuervorrichtung 16 umgesetzt sein. Solche Freigabekriterien von Seiten der Steuervorrichtung 16 können durch eine Erkennung eines ordnungsgemäß angeschlossenen, ladebereiten Fahrzeuges, durch eine Freigabe von Seiten der Fehlerstrom-Überwachungsvorrichtung 15 und/oder durch eine Freigabe von Seiten einer thermischen Überwachungsvorrichtung definiert sein.

Die Funktionseinheit Energiemessvorrichtung 18 der Ladeanschlussvorrichtung 1, insbesondere deren Mess- und Auswertungssoftware 32, 32', ist messtechnisch bzw. eichrechtlich zertifiziert. Insbesondere ist die Energiemessvorrichtung 18 konform zu nationalen und/oder internationalem Mess- und Eichvorschriften ausgebildet bzw. erfüllt sie die Anforderungen an länderspezifische Maß- und Eichgesetze. Demgegenüber ist eine funktionale Betriebssoftware 33, welche von der Steuervorrichtung 16 ausgeführt wird und die sonstigen Abläufe und Funktionen der Steuervorrichtung 16 bzw. der Ladeanschlussvorrichtung 1 bestimmt, nicht nach länderspezifischen Eich- und/oder Messvorschriften zertifiziert. Insbesondere ist die Betriebssoftware 33 der Ladeanschlussvorrichtung 1 nach länderspezifischen Gesetzen und/oder Richtlinien in Zusammenhang mit Mess- und/oder Eichgesetzen zertifiziert oder bewertet. Dadurch können umfassende Aufwendungen für derartige Bewertungen bzw. Zertifizierungen erübrigt werden. Nachdem die Betriebssoftware 33 nur funktionale Aspekte der Ladeanschlussvorrichtung 1, beispielsweise die Kommunikation mit dem Elektrofahrzeug oder eine Mensch-Maschine-Interaktion mit einem Benutzer der Ladeanschlussvorrichtung abdeckt, ist dies akzeptabel. Insbesondere wird dies durch eine Trennung von mess-und eichrechtlich relevanten Aspekten der Energiemessvorrichtung 18 von rein funktionalen bzw. betriebsablaufspezifischen Aspekten in Zusammenhang mit der Betriebssoftware 33 der Steuervorrichtung 16 vorteilhaft ermöglicht.

Die Ladeanschlussvorrichtung 1 umfasst weiters wenigstens eine Identifikationsvorrichtung 34 zur Identifizierung unterschiedlicher Benutzer der Ladeanschlussvorrichtung 1. Die Identifikationsvorrichtung 34 kann durch eine RFID-Lesevorrichtung, durch eine Pin-Tastatur, durch eine biometrische Erfassungsvorrichtung, oder dergleichen, gebildet sein. Die Energiemessvorrichtung 18 umfasst die oben genannte Energiedaten-Speichervorrichtung 24, welche als interner Speicher der Energiemessvorrichtung 18 ausgebildet ist.

In dieser Energiedaten-Speichervorrichtung 24 sind die jeweiligen Daten zu Ladevorgängen bzw. Energiebezügen der jeweiligen Benutzer hinterlegbar.

Dies erlaubt schnelle Verarbeitungs- bzw. Speicherzeiten bei relativ geringem Speicherbedarf. Vorteilhafterweise ist dabei die Energiedaten-Speichervorrichtung 24 in einem eichrechtlich relevanten Teilabschnitt der Energiemessvorrichtung 18 angeordnet. Insbesondere ist die Energiedaten-Speichervorrichtung 24 auf jener Platine angeordnet, auf welcher auch der Messdaten-Verwaltungscontroller 25 positioniert ist. Beispielsgemäß ist dies durch die gemeinsam genutzte Messplatine 27 realisiert.

Weiters ist es zweckmäßig, wenn die Energiemessvorrichtung 18 und die Steuervorrichtung 16 jeweils eigene bzw. separat zugeordnete Mikrocontroller mit jeweils eigener Firmware aufweisen. Beispielsgemäß weist die Energiemessvorrichtung 18 den Mess-Controller 21 auf, während die funktionale Steuervorrichtung 16 der Ladeanschlussvorrichtung 1 den eigenständigen Mikrocontroller 17 umfasst.

Die Energiemessvorrichtung 18 ist vorzugsweise über ein Bussystem 35, beispielsweise via CAN-Bus oder einen sonstigen seriellen Datenbus, mit der Steuervorrichtung 16 kommunikationsverbunden. Dabei ist vorgesehen, dass die Firmware der Steuervorrichtung 16 und die Firmware der Energiemessvorrichtung 18 auch ohne Datenverbindung zwischen der Steuervorrichtung 16 und der Energiemessvorrichtung 18 lauffähig sind. Dadurch wird ein möglichst rückwirkungsfreier, prinzipiell autarker Betrieb der jeweiligen Einheiten ermöglicht. Eine überwiegend programmgesteuerte bzw. softwaretechnische Implementierung in der Ladeanschlussvorrichtung 1 sieht vor, dass die Steuervorrichtung 16 dazu eingerichtet ist, vor jedem Start eines Ladevorganges eine datentechnische Kennung 36 der Energiemessvorrichtung 18, beispielsweise eine eineindeutige Seriennummer, auszulesen und auf Gültigkeit zu überprüfen. Von der Steuervorrichtung 16 bzw. Energiemessvorrichtung 18 ist dabei ein Start eines Ladevorganges unterbindbar, wenn diese datentechnische Kennung 36 als ungültig erkannt wird oder unbekannt ist. Manipulationen bzw. unerlaubte Zuordnungen zwischen einer manipulierten Energiemessvorrichtung 18 und/oder einer manipulierten Steuervorrichtung 16 können dadurch erschwert bzw. hintangehalten werden.

Weiters kann eine datentechnische Vernetzung einer Mehrzahl von Ladeanschlussvorrichtungen 1 mit einem zentralen Verwaltungssystem 37 vorgesehen sein. Die datentechnische Kommunikation zwischen den jeweiligen Ladeanschlussvorrichtungen 1 und dem zentralen Verwaltungssystem 37, insbesondere einem sogenannten Backend-System, kann beispielsweise via das Internet 38 vorgesehen sein. Hierfür umfasst die Ladeanschlussvorrichtung 1 eine erweiterte Kommunikationsbaugruppe 39 mit wenigstens einer datentechnischen Kommunikationsschnittstelle 40 zur Fernkommunikation mit dem zentralen Verwaltungssystem 37.

Das Ausführungsbeispiel zeigt mögliche Ausführungsvarianten, wobei an dieser Stelle bemerkt sei, dass die Erfindung nicht auf die speziell dargestellten Ausführungsvarianten eingeschränkt ist und nicht alle der dargestellten Ausführungsvarianten umfassen muss. Zudem sind diverse Kombinationen der einzelnen Ausführungsvarianten untereinander möglich sind und liegt diese Variationsmöglichkeit aufgrund der Lehre zum technischen Handeln durch gegenständliche Erfindung im Können des auf diesem technischen Gebiet tätigen Fachmannes.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden. Soweit in der Beschreibung Ausführungsformen oder Merkmalskombinationen beschrieben sind, die nicht sämtliche Merkmale des Anspruchs 1 aufweisen, dienen diese lediglich dem Verständnis der technischen Lehre oder stellen nicht beanspruchte Vergleichs- bzw. Hintergrundbeispiele dar.

Die Erfindung im Sinne der vorliegenden Anmeldung ist durch die Ansprüche, insbesondere durch Anspruch 1, definiert.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

| | | | |
|---|---|---|---|
| 1 | Ladeanschlussvorrichtung | 29 | Freigabe- und/oder Sperrsignal |
| 2 | Gehäuse | 30 | Steuerleitung |
| 3 | vorderes Gehäuseteil | 31 | Leistungsschalter-Ansteuereinheit |
| 4 | hinteres Gehäuseteil | 31' | Steuerleitung |
| 5 | weitere Gehäuseteile | 32, 32' | Mess- und Auswertungssoftware |
| 6 | erste Schnittstelle | | |
| 7 | zweite Schnittstelle | 33 | Betriebssoftware |
| 8 | Steckbuchse | 34 | Identifikationsvorrichtung |
| 9 | zweite Schnittstelle | 35 | Bussystem |
| 10 | Ladekabelabgang | 36 | datentechnische Kennung |
| 11 | Ladekabelhalterung | 37 | zentrales Verwaltungssystem |
| 12 | Leiterplatte | 38 | Internet |
| 13 | Anschlussklemmen | 39 | Kommunikationsbaugruppe |
| 14 | Leistungsschaltvorrichtung | 40 | Kommunikationsschnittstelle |
| 15 | Fehlerstrom-Überwachungsvorrichtung | | |
| 16 | Steuervorrichtung | | |
| 17 | erster Mikrocontroller | | |
| 18 | Energiemessvorrichtung | | |
| 19 | Spannungsgeber | | |
| 20 | Stromwandler | | |
| 21 | Mess-Controller | | |
| 22 | Kalibrierdaten-Speichervorrichtung | | |
| 23 | Hauptplatine | | |
| 24 | Energiedaten-Speichervorrichtung | | |
| 25 | Messdaten-Verwaltungscontroller | | |
| 26 | Display | | |
| 27 | Messplatine | | |
| 28 | Steckerschnittstelle | | |

## Patentansprüche

1. Ladeanschlussvorrichtung (1) für Elektrofahrzeuge, umfassend
- zumindest eine erste Schnittstelle (6) zum Beziehen von elektrischer Energie aus einem ortsfesten Stromversorgungsnetz,
- zumindest eine zweite Schnittstelle (7, 9) zur gesteuerten Abgabe von elektrischer Energie an ein Elektrofahrzeug,
- eine elektronische Steuervorrichtung (16) mit welcher ein Ladevorgang eines Elektrofahrzeugs überwachbar und/oder beeinflussbar ist,
- eine Leistungsschaltvorrichtung (14) mit einem ersten Schaltzustand in welchem eine Bereitstellung von elektrischer Energie an der zumindest einen zweiten Schnittstelle (7, 9) freischaltbar ist und mit einem zweiten Schaltzustand in welchem eine Bereitstellung von elektrischer Energie an der zumindest einen zweiten Schnittstelle unterbindbar ist,
- eine Energiemessvorrichtung (18) zum Messen der über die Ladeanschlussvorrichtung (1) an ein Elektrofahrzeug abgegebenen elektrischen Energie,
- eine elektronische Energiedaten-Speichervorrichtung (24) zum Speichern der von der Energiemessvorrichtung (18) gemessenen Energiedaten, welche elektronische Energiedaten-Speichervorrichtung (24) als interner Speicher der Energiemessvorrichtung (18) ausgebildet ist;
- ein Gehäuse (2) in welchem wenigstens die elektronische Steuervorrichtung (16) und die Leistungsschaltvorrichtung (14) und gegebenenfalls die Energiemessvorrichtung (18) untergebracht sind,
**dadurch gekennzeichnet, dass**
in der Energiedaten-Speichervorrichtung (24) der Energiemessvorrichtung (18) die Energiebezüge von mehreren unterschiedlichen Benutzern je Ladevorgang hinterlegbar sind, und dass diese Energiedaten in datentechnisch unsignierter Form in der elektronischen Energiedaten-Speichervorrichtung (24) hinterlegt werden, wobei
die Energiedaten-Speichervorrichtung (24) in einem eichrechtlich relevanten Teilabschnitt der Energiemessvorrichtung (18) angeordnet ist,
wobei eine Mess- und Auswertungssoftware (32, 32') der Energiemessvorrichtung (18) nach länderspezifischen Eichgesetzen und/oder Messrichtlinien zertifiziert und/oder bewertet ist, und wobei die Steuervorrichtung (16) in ihren Abläufen und Funktionen zumindest teilweise durch Betriebssoftware (33) gesteuert und/oder beeinflusst ist und diese Betriebssoftware (33) nicht nach länderspezifischen Eichgesetzen und/oder Messrichtlinien zertifiziert und/oder bewertet ist.

2. Ladeanschlussvorrichtung nach Anspruch 1, **dadurch gekennzeichnet, dass** die Energiemessvorrichtung (18) und die Steuervorrichtung (16) jeweils eigene Mikrocontroller (21, 25; 17) mit jeweils eigener Firmware aufweisen.

3. Ladeanschlussvorrichtung nach einem der vorhergehenden Ansprüche, **dadurch gekennzeichnet, dass** die Energiemessvorrichtung (18) dazu eingerichtet ist, die gespeicherten Energiedaten an die Steuervorrichtung (16) der Ladeanschlussvorrichtung (1) zu übergeben, und dass die Steuervorrichtung (16) dazu eingerichtet ist, diese Energiedaten in datentechnisch signierter Form an ein externes, zentrales Verwaltungssystem (38) zu übergeben.

4. Ladeanschlussvorrichtung nach einem der vorhergehenden Ansprüche, **dadurch gekennzeichnet, dass** die Steuervorrichtung (16) dazu eingerichtet ist, die Energiedaten in einem standardisierten, vordefinierten Datenformat für Energiezählvorrichtungen aufzubereiten.

5. Ladeanschlussvorrichtung nach einem der vorhergehenden Ansprüche, **dadurch gekennzeichnet, dass** die Energiemessvorrichtung (18) dazu eingerichtet ist, eine datentechnische Prüfsumme zu den Energiedaten zu berechnen und diese Prüfsumme gemeinsam mit den Energiedaten in datentechnisch unsignierter Form in der Energiedaten-Spei chervorrichtung (24) zu hinterlegen.

6. Ladeanschlussvorrichtung nach einem der vorhergehenden Ansprüche, **dadurch gekennzeichnet, dass** eine Identifikationsvorrichtung (34) zur Identifizierung unterschiedlicher Benutzer der Ladeanschlussvorrichtung (1) ausgebildet ist.

7. Ladeanschlussvorrichtung nach einem der Ansprüche 3 bis 6, **dadurch gekennzeichnet, dass** die Energiemessvorrichtung (18) und die Steuervorrichtung (16) dazu eingerichtet sind, am Ende eines Ladevorganges ein datentechnisch signiertes Datenpaket mit allen Informationen über den abgeschlossenen Ladevorgang an das zentrale Verwaltungssystem (38) zu übertragen.

## Claims

1. A charging connector device (1) for electric vehicles, comprising
- at least one first interface (6) for drawing electrical energy from a stationary power supply network,
- at least one second interface (7, 9) for the controlled delivery of electrical energy to an electric vehicle,
- an electronic control device (16) with which a charging operation of an electric vehicle can be monitored and/or influenced,
- a power switching device (14) having a first switching state in which a supply of electrical energy at the at least one second interface (7, 9) can be enabled, and a second switching state in which the supply of electrical energy at the at least one second interface can be disabled,
- an energy measurement device (18) for measuring the electrical energy delivered to an electric vehicle via the charging connector device (1),
- an electronic energy data storage device (24) for storing the energy data measured by the energy measurement device (18), which electronic energy data storage device (24) is configured as an internal memory of the energy measurement device (18);
- a housing (2) in which at least the electronic control device (16) and the power switching device (14), and optionally the energy measurement device (18), are accommodated,
**characterized in that**
in the energy data storage device (24) of the energy measurement device (18), the energy consumption of multiple different users per charging operation can be stored, and that this energy data is stored in an unsigned data format in the electronic energy data storage device (24), wherein
the energy data storage device (24) is located in a section of the energy measurement device (18) that is relevant to calibration regulations,
wherein a measurement and evaluation software (32, 32') of the energy measurement device (18) is certified and/or evaluated in accordance with country-specific calibration laws and/or measurement guidelines,
and wherein the control device (16) is, at least partially, controlled and/or influenced in its operations and functions by operating software (33), and this operating software (33) is not certified and/or evaluated in accordance with country-specific calibration laws and/or measurement guidelines.

2. The charging connector device according to claim 1, **characterized in that** the energy measurement device (18) and the control device (16) each have their own microcontroller (21, 25; 17), each with its own firmware.

3. The charging connector device according to one of the preceding claims, **characterized in that** the energy measurement device (18) is configured to transfer the stored energy data to the control device (16) of the charging connector device (1), and that the control device (16) is configured to transmit this energy data in a signed data format to an external, central management system (38).

4. The charging connector device according to one of the preceding claims, **characterized in that** the control device (16) is configured to format the energy data in a standardized, predefined data format for energy metering devices.

5. The charging connector device according to one of the preceding claims, **characterized in that** the energy measurement device (18) is configured to calculate a data-technical checksum for the energy data and to store this checksum together with the energy data in an unsigned data format in the energy data storage device (24).

6. The charging connector device according to one of the preceding claims, **characterized in that** an identification device (34) is configured to identify different users of the charging connector device (1).

7. The charging connector device according to one of claims 3 to 6, **characterized in that** the energy measurement device (18) and the control device (16) are configured to transmit, at the end of a charging operation, a data-technically signed data packet containing all information regarding the completed charging operation to the central management system (38).

## Revendications

1. Dispositif formant borne de recharge (1) pour des véhicules électriques, comprenant
- au moins une première interface (6) permettant d'obtenir de l'énergie électrique à partir d'un réseau d'alimentation électrique fixe,
- au moins une seconde interface (7, 9) permettant de fournir de manière commandée de l'énergie électrique à un véhicule électrique,
- un dispositif de commande électronique (16) grâce auquel une opération de charge d'un véhicule électrique peut être surveillée et/ou influencée,
- un dispositif de commutation de puissance (14) avec un premier état de commutation dans lequel une fourniture en énergie électrique au niveau de la au moins une seconde interface (7, 9) peut être activée et avec un deuxième état de commutation dans lequel une fourniture en énergie électrique au niveau de la au moins une seconde interface peut être inhibée,
- un dispositif de mesure d'énergie (18) permettant de mesurer l'énergie électrique fournie à un véhicule électrique par l'intermédiaire du dispositif formant borne de recharge (1),
- un dispositif électronique de stockage de données énergétiques (24) permettant de stocker les données énergétiques mesurées par le dispositif de mesure d'énergie (18), lequel dispositif électronique de stockage de données énergétiques (24) est réalisé sous la forme d'une mémoire interne du dispositif de mesure d'énergie (18) ;
- un boîtier (2) dans lequel sont logés au moins le dispositif de commande électronique (16) et le dispositif de commutation de puissance (14) et éventuellement le dispositif de mesure d'énergie (18),
**caractérisé en ce que**
les références énergétiques de plusieurs utilisateurs différents peuvent être stockées pour chaque opération de charge dans le dispositif de stockage de données énergétiques (24) du dispositif de mesure d'énergie (18), et **en ce que** lesdites données énergétiques sont stockées dans le dispositif électronique de stockage de données énergétiques (24) sous une forme non signée numériquement, dans lequel le dispositif de stockage de données énergétiques (24) est agencé dans une sous-section, en conformité avec la loi sur l'étalonnage, du dispositif de mesure d'énergie (18),
dans lequel un logiciel de mesure et d'évaluation (32, 32') du dispositif de mesure d'énergie (18) est certifié et/ou évalué selon les lois d'étalonnage et/ou les directives de métrologie spécifiques à chaque pays, et dans lequel le dispositif de commande (16) est commandé et/ou influencé dans ses procédures et fonctions au moins partiellement par le logiciel d'exploitation (33) et ledit logiciel d'exploitation (33) n'est pas certifié et/ou évalué selon les lois d'étalonnage et/ou les directives de métrologie spécifiques à chaque pays.

2. Dispositif formant borne de recharge selon la revendication 1, **caractérisé en ce que** le dispositif de mesure d'énergie (18) et le dispositif de commande (16) présentent respectivement leurs propres microcontrôleurs (21, 25 ; 17) munis de respectivement leur propre micrologiciel.

3. Dispositif formant borne de recharge selon l'une quelconque des revendications précédentes, **caractérisé en ce que** le dispositif de mesure d'énergie (18) est conçu pour transmettre les données énergétiques stockées au dispositif de commande (16) du dispositif formant borne de recharge (1), et **en ce que** le dispositif de commande (16) est conçu pour transmettre lesdites données énergétiques sous une forme signée numériquement à un système de gestion central externe (38).

4. Dispositif formant borne de recharge selon l'une quelconque des revendications précédentes, **caractérisé en ce que** le dispositif de commande (16) est conçu pour préparer les données énergétiques dans un format de données standardisé et prédéfini pour les dispositifs de comptage d'énergie.

5. Dispositif formant borne de recharge selon l'une quelconque des revendications précédentes, **caractérisé en ce que** le dispositif de mesure d'énergie (18) est conçu pour calculer une somme de contrôle numérique pour les données énergétiques et pour enregistrer dans le dispositif de stockage de données énergétiques (24) ladite somme de contrôle avec les données énergétiques sous une forme non signée numériquement.

6. Dispositif formant borne de recharge selon l'une quelconque des revendications précédentes, **caractérisé en ce qu'**un dispositif d'identification (34) est réalisé afin d'identifier les différents utilisateurs du dispositif formant borne de recharge (1).

7. Dispositif formant borne de recharge selon l'une quelconque des revendications 3 à 6, **caractérisé en ce que** le dispositif de mesure d'énergie (18) et le dispositif de commande (16) sont conçus pour, à la fin d'une opération de charge, transmettre au système de gestion central (38) un paquet de données signé numériquement et comprenant l'ensemble des informations sur l'opération de charge terminée.
